# EUROPEAN PATENT SPECIFICATION

(11) **EP 2 491 411 B1**
(45) Date of publication and mention of the grant of the patent: **15.04.2015**
(21) Application number: 10775879.9
(22) Date of filing: 22.10.2010
(51) Int. Cl.: G01R 31/02, H02J 9/06

(54) **METHOD AND APPLIANCE FOR THE DETECTION OF CURRENT DISCONTINUITY IN SWITCHED ELECTRICAL POINT OF AN ALTERNATING NETWORK**
VERFAHREN UND IDENTIFIKATIONSGERÄT FÜR EINEN LEISTUNGSEINRUCH BEI EINEM ZWISCHENGESCHALTETEN ELEKTRISCHEN WECHSELSTROMKNOTEN
PROCÉDÉ ET DISPOSITIF D'IDENTIFICATION DE COUPURE D'ALIMENTATION DANS UN POINT ÉLECTRIQUE INTERMITTENT DU RÉSEAU ALTERNATIF

(30) Priority: 23.10.2009 GR 20090100584
(43) Date of publication of application: 29.08.2012
(73) Proprietor: Katsoulis, Alexander, North Rocks, NSW 2150 (AU)
(72) Inventor: Katsoulis, Alexander, North Rocks, NSW 2150 (AU)
(74) Representative: Panagiotidou, Effimia
(86) International application number: PCT/GR2010/000047
(87) International publication number: WO 2011/048436

(56) References cited:
- GB-A- 2 199 171
- JP-A- 11 275 777
- US-A1- 2002 153 779
- US-A1- 2006 119 368

## Description

The invention pertains to the field of electronic/electrical engineering and relates to a method of detecting whether the interruption of current to an electrified load, connected to a switched electrical point of an alternating network, was intended by the user or conversely if the interruption of current is the result of a general failure (from the electricity provider or due to damage in the distribution board), or finally if the point is electrified.

The method can be applied to any electrified switched point of 2 conductors switched phase (L) and non switched neutral (N) of an alternating network, independent of the load being powered, e.g. lamp, ceiling fan, etc. (or switched neutral (N) and non switched phase (L) according to national specifications of each country). Implementation of the method requires the presence of a rechargeable battery.

The invention is referred to an appliance implementing the method.

In the current state of the art, appliances which operate with rechargeable backup batteries (for example uninterruptable light luminaries, security lighting, wireless smoke detectors with rechargeable batteries, wireless security intrusion sensors, etc.) require, for their proper functionality, permanent AC power source, so that their batteries can be charged during the period of current supply existence. When the current supply is discontinued, the batteries activate the specified functions of the appliances. Document US 2006119368 describes a monitoring system based on microprocessor evaluation of the measured AC input voltage.

The technical problems that occur during the installation and use of these appliances are numerous:
A first technical problem is that for their operation and charging of their battery, when connected to the common urban alternating current network, require the existence of an undisruptcd sine wave current, where V(t) = Vpk Sine (ωt), where ω = 2πf, where Vpk and f are defined by the electricity providers in each country (e.g. Vpk=325V f=50Hz). Consequently the appliances of uninterruptible or emergency operation cannot be installed at existing switched point fittings without the simultaneous existence or installation of a third conductor of permanent current supply, despite the fact that switched point fittings in a building, normally located high, are by nature more suitable than the uninterruptible supply points for the said installations.

The reason appliances of uninterruptible or emergency operation cannot be placed in switched points, is because without the existence of this additional (third) conductor of permanent supply, today's techniques are not able to discern if the interruption was intended by the user, using the switch, or if it was due to a general failure (by the electricity provider or due to damage to the distribution board). Therefore if these appliances are connected to a switched point outlet, every interruption of their electrification, be it by the user using the switch, or general disruption (namely due to the electricity provider or due to damage to the distribution board), will lead to the same result: the appliances would enter backup operation with their battery and of course their battery charging operation will stop. However, the above is as serious disadvantage in today's technique because the backup function of appliances is planned only for the situation where the electrical failure is general, namely by the electricity provider or due to distribution board damage and not for the case in which the user voluntarily disrupted the electrification. Thus, there will be needless waste of the backup battery of the uninterruptible appliances. Additionally (specially if the appliance that was installed at the switch point was a safety light), each time the user would disconnect the electrification, wishing to stop illuminating the room, it would enter it's light operation, thereby negating the command of the user who desired the light switched off.

Yet another technical problem arises when such appliances with rechargeable batteries e.g. security lighting, wireless smoke detectors etc., need to be retro fitted in existing buildings - such as common areas of multi-apartment dwellings, corridors, office spaces, etc. - when there was no plan, during construction, for the installation of such appliances, namely the existence of the third conductor of permanent current supply. Here appears the disadvantage that appliances of today's level of technology cannot exploit the existing switched electrical points (despite the fact that these points are appropriate for their installation) without any requirement for extensive contractual and electrical work for the installation of the third conductor of uninterruptible non voluntarily interrupted current supply to the electrified point where those appliances will be connected. Thus, retrofit installation for such appliances in such buildings requires significant cost for new electrical fixtures with all the known consequences, grouting, plastering, painting etc, disproportionately higher than the cost of the appliances themselves. Furthermore, there is an ecological burden for the environment with the use of additional copper for the third conductor considering the energy requirement for its production.

The present invention solves the above technical problems.

In brief, the method as set forth in claim 1, is implemented and operates both in full sine wave period (0<ωt<2π;) and in half sine wave period (0<ωt<π) or (π<ωt<2π) of alternating current (AC), but also in the absence of any period (electrification interruption, T=infinite).

It uses an alternating voltage to square wave Pulse Width Modulation converter measuring circuit - (PWM Converter). With an optocoupler this information is transferred to the microcontroller. The microcontroller measures the time of half period (t) and period (T), and calculates the ratio between them t/T and calculates the network voltage, hence determining
whether there is no supply disruption to the existing electrical point,
or if there is interruption in power supply:
a) because of a general failure by the electricity provider or due to damage in the distribution board this including the case in which there is voltage sag (as this term is defined by the international organizations particularly in the security systems),
   or
b) because there was a power interruption so intended by the user via the switch of the specific electrified point.

In the first case (a), the rechargeable battery is put into operation
while
in the second case (b), the user's command is executed for electrical disconnection to the existing load (AC) and the rechargeable battery does not enter into operation but continuous its charge.

The invention also refers to a device or an appliance according to claim 7 for implementing the method.

The appliance is connected to a switched point electrical outlet.

The appliance can operate in two ways: equipped with its own rechargeable battery on not.

In the first form, where the appliance offers its own rechargeable battery, it constitutes a new autonomous appliance which does not exist to date, aimed at load function checking (e.g. burned out or malfunctioning light bulb), or test for possible interruption of electrification (e.g. due to fuse damage).

Thus, as an example, it could be used in.the road lighting columns of local or national roads which also operate as switched electrical points. Then, thanks to the backup battery which the appliance is equipped with and using telematic methods, it will be capable to transmit to the relevant control center the information that a section (block) of street lighting bulbs has been put out of service due to electrification interruption or burned out fuse, or that a specific light bulb is malfunctioning/burned out. Further, the system, by using GPS (Global Positioning System) technology, would be able to send the exact geographical coordinates of the damage.

Also, having its own rechargeable battery, the appliance can - by using LED lamps - operate as a new type of safety light as well. In this form, the appliance is used when at the switched electrified point there is a connected load such as e.g. lamp, bracket lamp, ceiling fan, etc.

In the cases above where the appliance is equipped with its own rechargeable battery, it is connected between the switched electrified point and its electric load (e.g. lamp, applique, etc.) terminating at a new connection point (wire terminal connector) for the connection of the existing electric load. As a result of this method, the new connection point retains all of its characteristics as a switched electrified point. After the connection of the electric load to the appliances new connection point, the load may continue to be controlled by the manual switch, or by automatic mechanisms that are activated by the user in an indirect way e.g. staircase lighting in multi storey buildings, or without user intervention such as e.g. lighting control with electronic timers, etc.

In its second form, where the appliance is not equipped with its own rechargeable battery, constitutes a subsystem (module) and it is embedded in an appliance of uninterruptible or emergency operation, namely a foreign (host) appliance which uses its own rechargeable battery and belongs to today's level of technology, e.g. security light, smoke detector, etc. The electrical connection with the host appliance is done in a manner similar to the above, while their communication is implemented with a serial channel suitable for every host.

The invention is implemented in the same way in appliances that instead of rechargeable battery they are equipped with super capacitors.

The invention is implemented the same way in cases when there is no general failure but a voltage sag where it can detect discrete voltage levels and make relative decisions (as per voltage sag specifications defined by International Organizations specifically for security systems).

In today's state of the art there is no other method and appliance that implements a method, such as this, capable of discerning that the discontinuity of current to an electrified load, a) was due to a general failure (by the electricity provider or damage to the distribution board) or b) it was voluntarily disrupted by the user,
using the same switched electrified point of the existing load (AC)
and without the existence of a third conductor of uninterrupted supply.

The major advantage of this method and the appliance implementing it, is that it allows the installation of all appliances that operate with rechargeable battery (such as security lights, smoke detectors, alarms, etc) at points of switched electrification, while with current technology they would require for their charging an electrical point of uninterruptible line (non switched phase and neutral).

By principle the present method allows utilization of all the existing switched electrical points which, normally located high on ceilings, are more attractive for the installation of such appliances allowing their installation at such points.

A further advantage is that thanks to this method the appliance's backup up battery is not wasted unnecessarily as it would enter backup operation only when there is a general failure by the electricity provider or damage to the distribution board.

An additional advantage is that the implementation of the present method and operation of the appliance implementing it, do not require modifications or intervention to the conventional electrical 2 wire installation, that is: switched phase and neutral or vice versa. It requires only a rectification circuit connection (e.g. a diode) to the switch controlling the line to the electrified point, whether this point is controlled by a manual switch or by automations activated by the user in an indirect way, or even without any user intervention such as for example the case with timers or other automatic devices.

From this characteristic spawns a further important advantage that the implementation of the present method and the installation of the appliance implementing it, imposes a much lower cost because it utilizes the switched electrified point fixtures that exist today and opens new exploitation possibilities for these points.

The appliance offers galvanic isolation from the network for all electronic circuits and batteries, thus providing complete safety in case of battery replacement by the user.

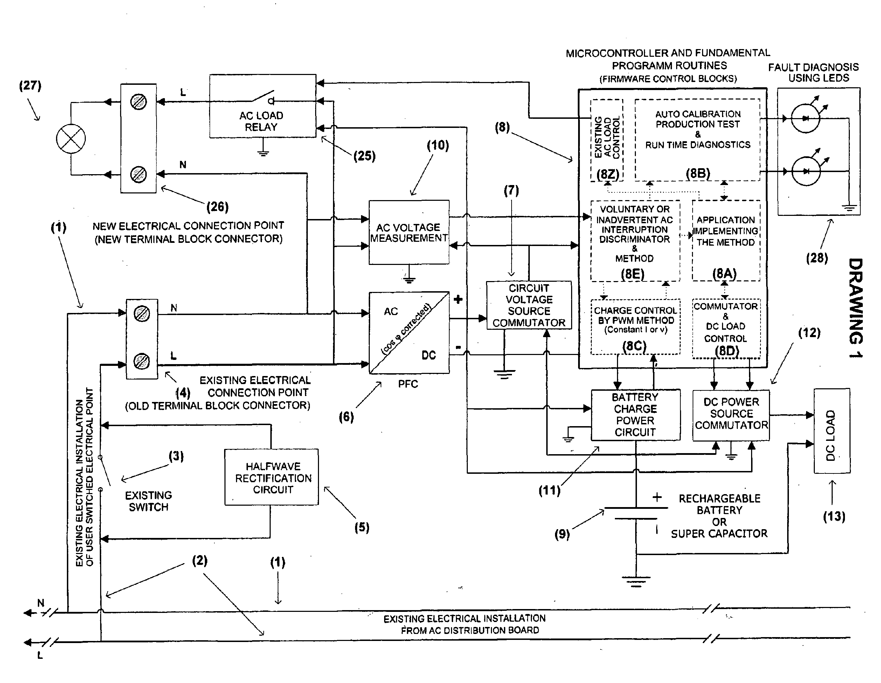

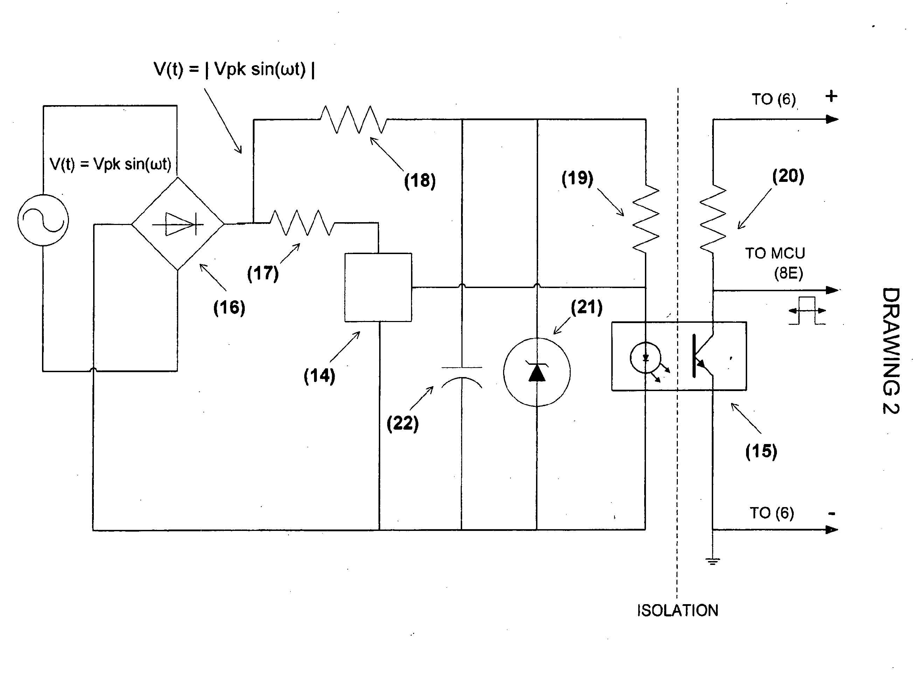

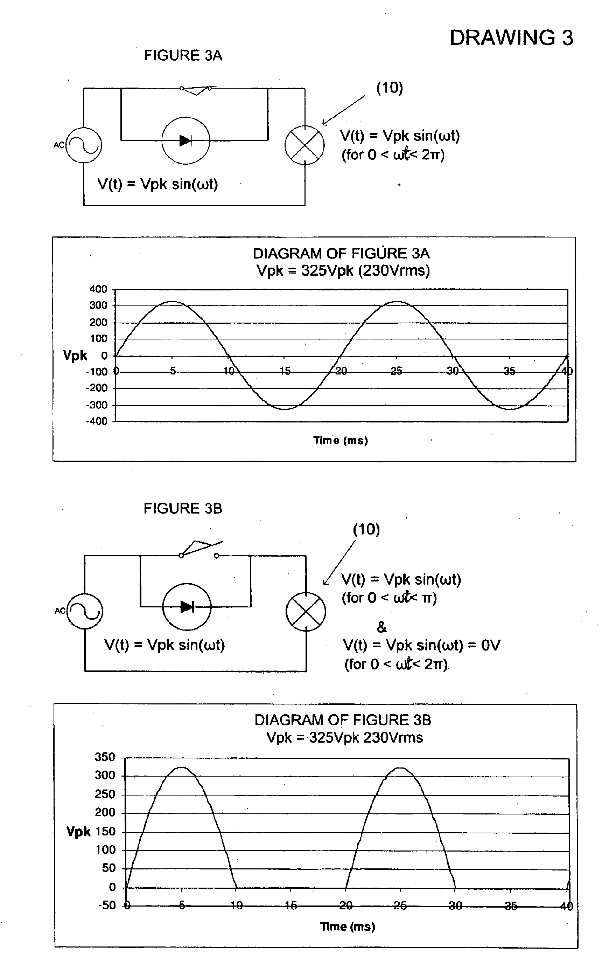

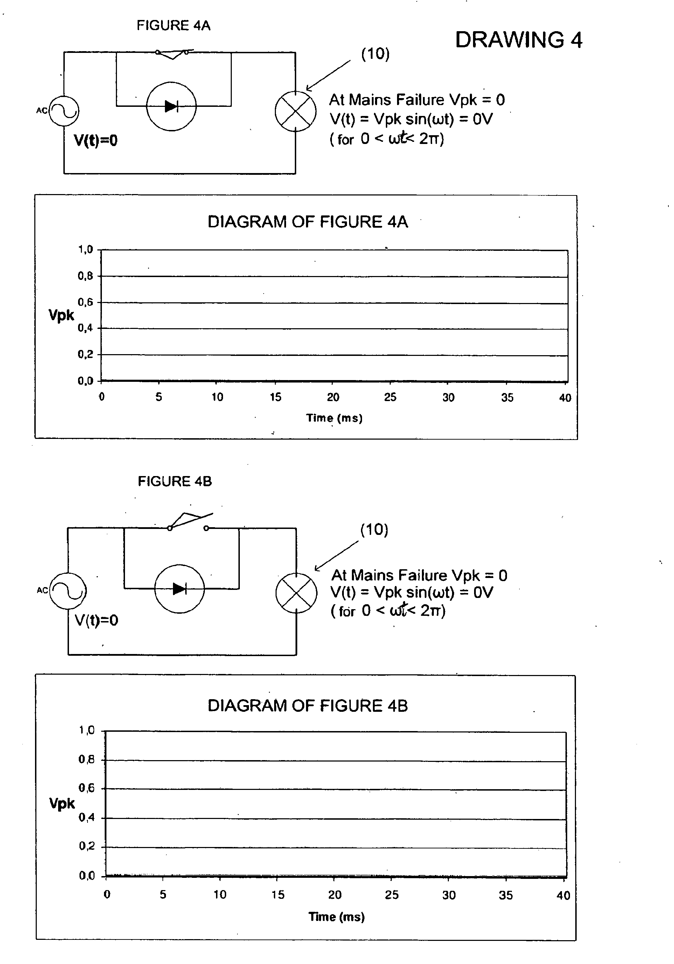

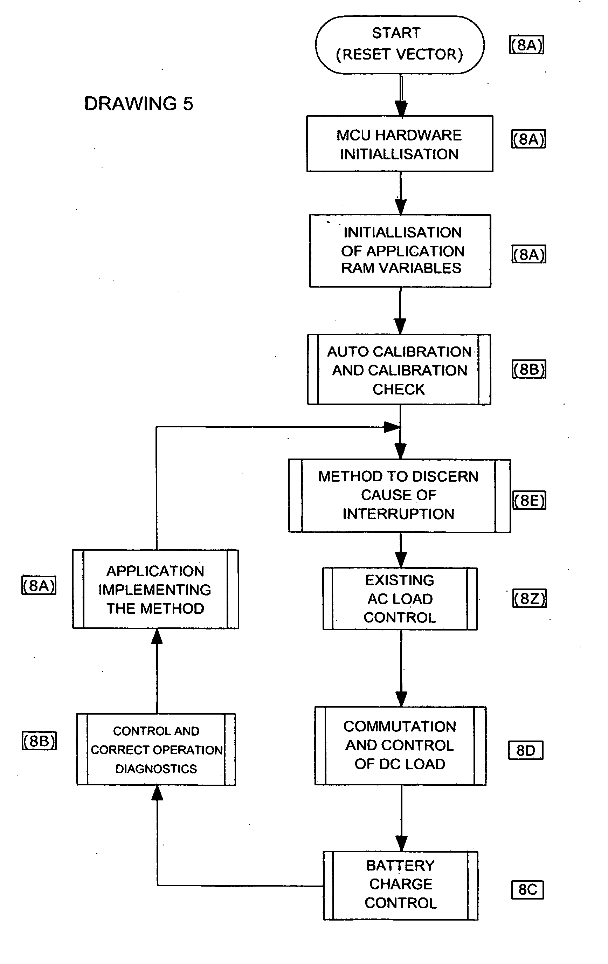

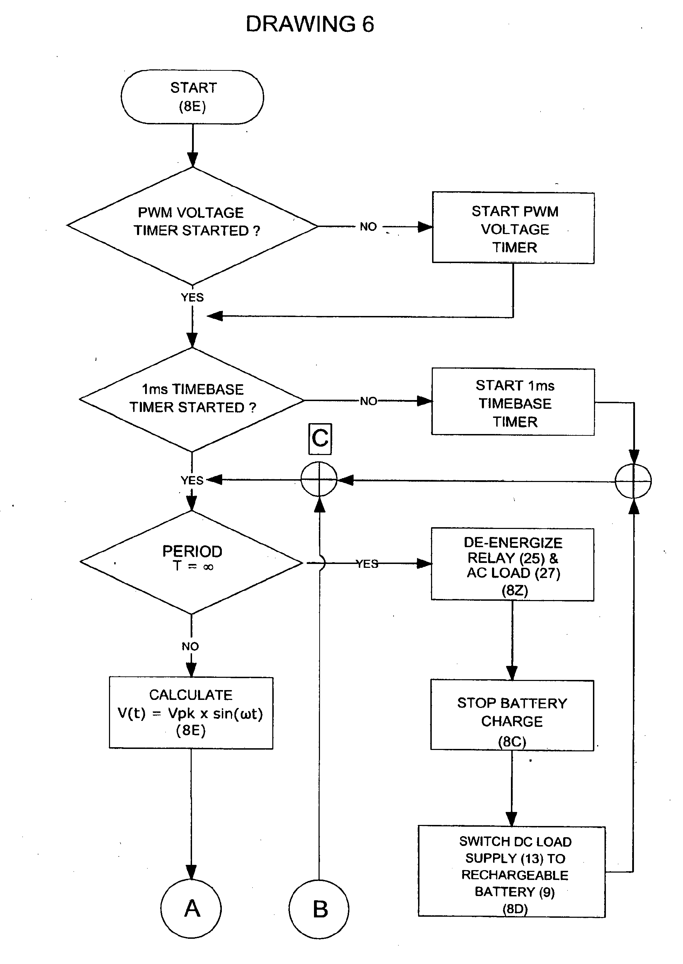

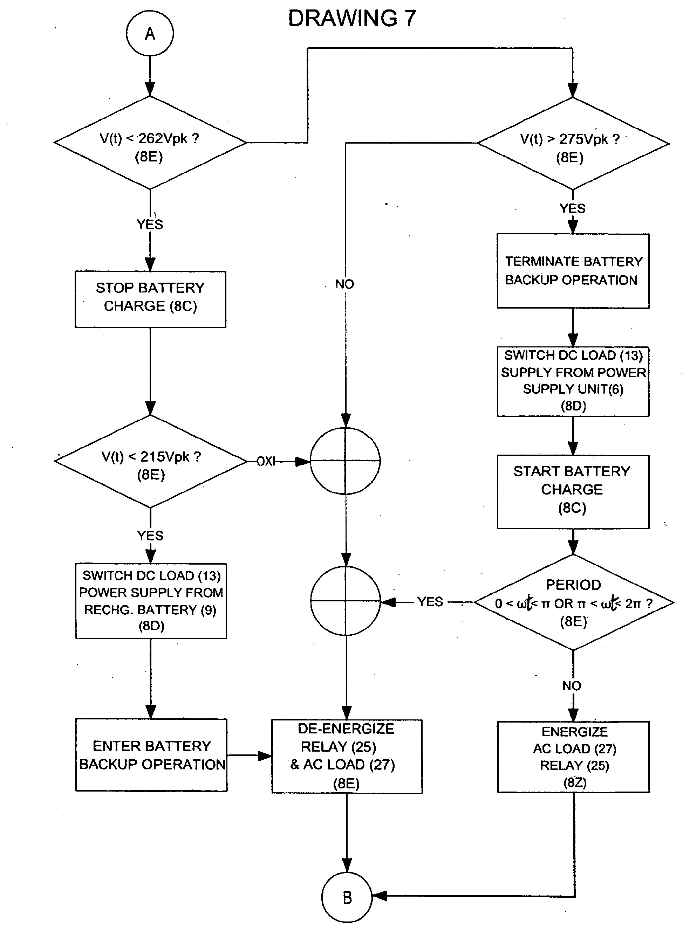

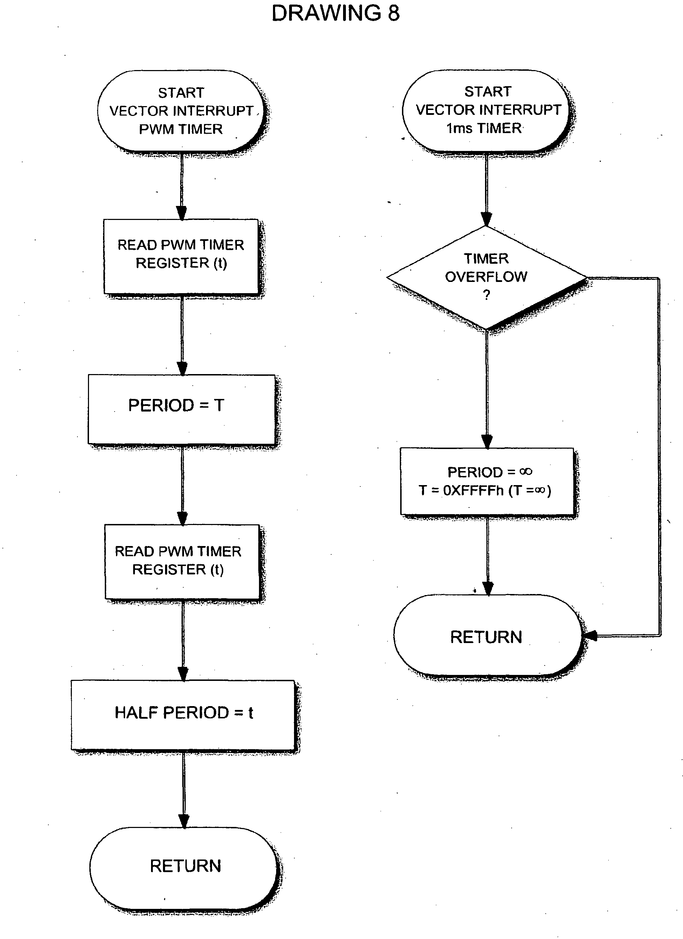

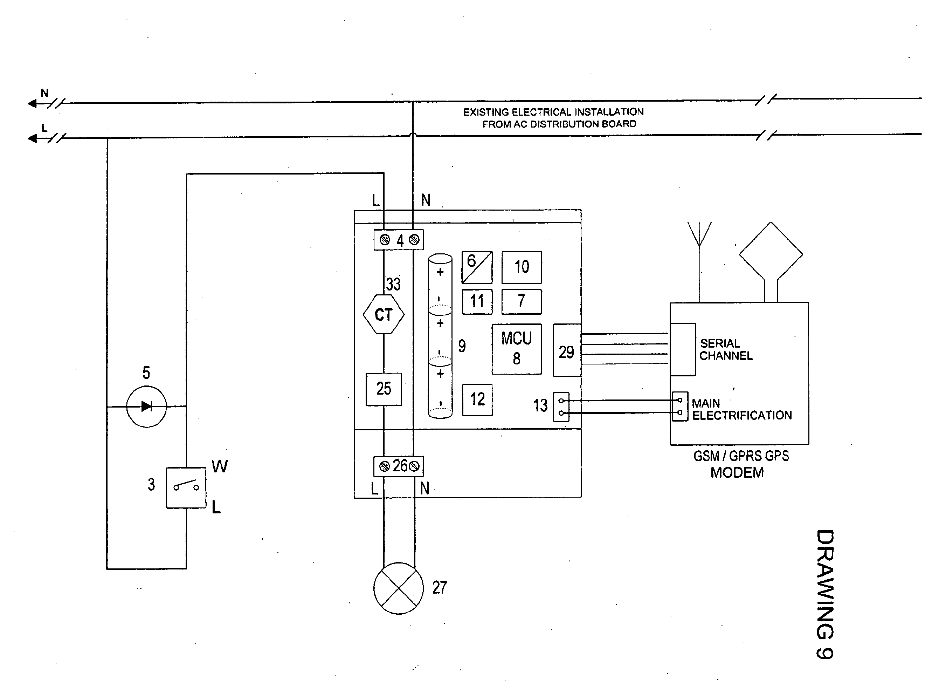

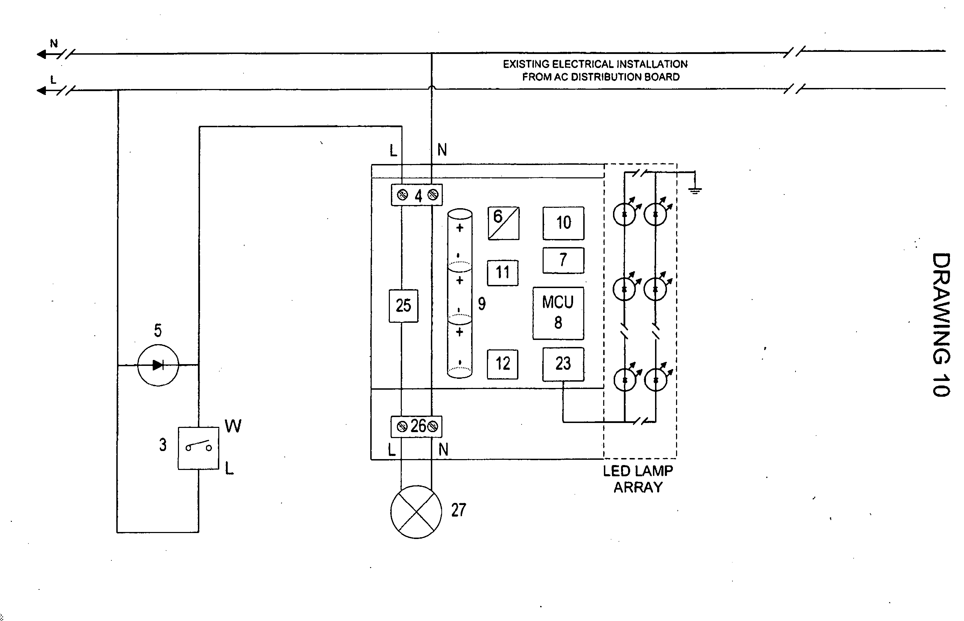

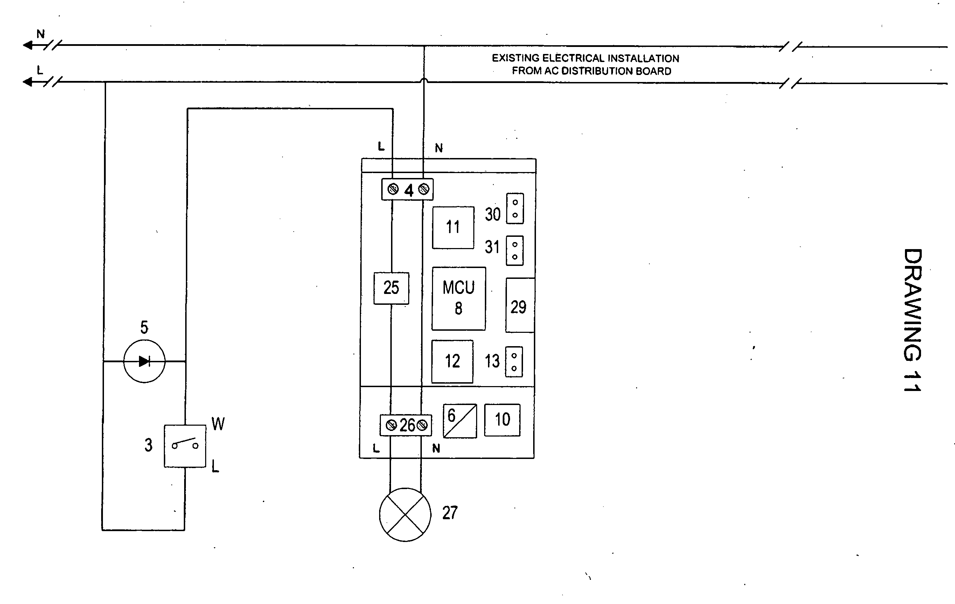

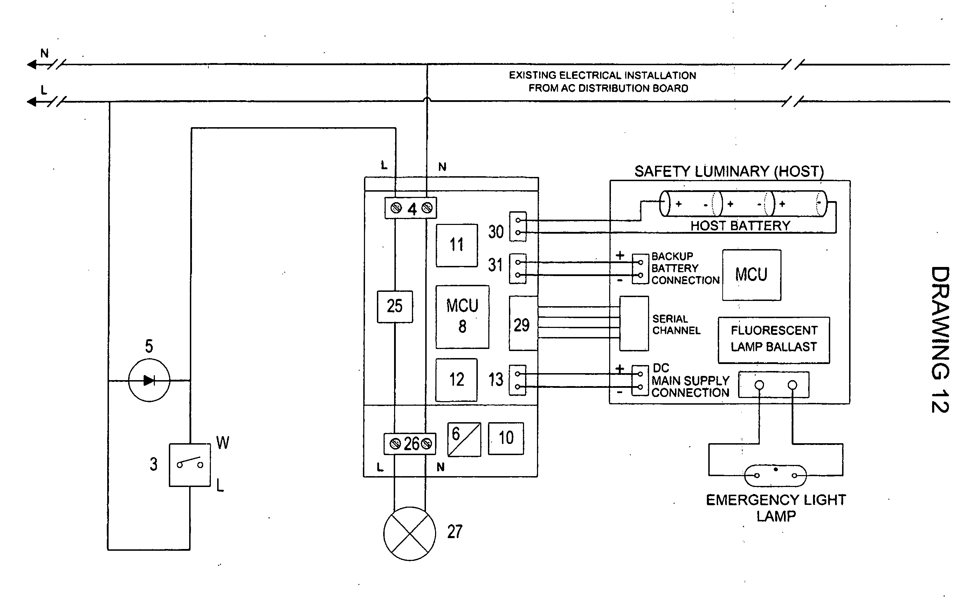

The attached drawings briefly describe the following:
Drawing 1 depicts the electrical layout for the application of the method to discern the cause of current interruption to a switched electrical point, at a block diagram level.
Drawing 2 depicts the part arrangement of the alternating voltage (AC) to square wave Pulse Width Modulation converter (PWM converter) measuring circuit.
Drawing 3 depicts the two different operation modes which may appear in a switched electrified point, by user initiative: namely, both, in the case where the user turns the switch off (Figure 3A) and in the case where the user voluntary turns the switch on (Figure 3B), including relative per case waveforms respectively, when the method is implemented.
Drawing 4 depicts the two different operation modes which may exist, at a switched electrified point when there is a general electrical current failure independent of user volition (namely either due to a general electrical current failure by the provider or due to damage in the distribution board) both, in the case where the switch was closed at the moment of interruption/damage (Figure 4A) and also in the case where the switch was open at the moment of interruption/damage (Figure 4B), including relative per case waveforms respectively, when the method is implemented.
Drawing 5 depicts the summary flow chart of the process and decision sequences for the implementation of the method as illustrated in drawing 1, but also for the implementation of the method by the appliance.
Drawings 6 and 7 depict the detailed flow chart of the process and decision sequences for the implementation of the method as illustrated in drawing 1, but also for the implementation of the method by the appliance.
Drawing 8 depicts a detailed flow chart of the Vector Interrupt Service routines of the two timers, the PWM timer which is used for the voltage measurement and the 1ms timer which is used for overflow sampling of the PWM timer illustrated in figure 6.
Drawing 9 depicts the connection of the appliance which implements the method of drawing 1, when this includes its own rechargeable battery, thus constituting a new autonomous appliance which is useful, for example, in road lighting installations where by use of telemetric methods (external appliances GSM/GPRS modem) it can alert the control center for problem occurrence (blocks of lights out of service, electrical failure, etc.), while with GPS (Global Positioning System) technology it would notify the exact geographical coordinates of the damage.
Drawing 10 depicts the connection of the appliance which implements the method of drawing 1, when this includes its own rechargeable battery, thus constituting a new autonomous appliance which is useful, for example, as an autonomous safety light with LED lamps.
Drawing 11 depicts the connection of an appliance which implements the method of drawing 1, when this does not include its own rechargeable battery and is connected between a switched electrified point and the circuit of a safety light of today's technology level (or another appliance with rechargeable battery - host appliance), using a serial data channel e.g. I2C, SPI, UART.
Drawing 12 depicts the way in which the appliance of drawing 11 is connected to a safety light appliance which uses its own rechargeable battery and belongs to today's state of the art.

A non-restrictive application of the method and the appliance which implements it, is described below with reference to the drawings.

### Respecting the method (drawings 1 to 8):

As indicated in drawing 1, which portrays the way of implementing this method, a typical electrical installation is a prime requirement, a neutral wire conductor (1) (symbolized with the letter "N"), distributed to all the switched or non switched points, such as switches, plugs with switches, etc., and a phase wire conductor (2) (symbolized with the letter "L") which via switch (3) routes to the point of electrical connection (terminal connector) (4), where the neutral conductor (N) is also directly terminated.

Then, the two conductors are connected to the power supply unit (6) and to the alternating voltage to square wave Pulse Width Modulation converter (PWM converter) measuring circuit (10). Then, the phase conductor L is connected to the existing AC load control relay unit (25) and terminates with neutral wire conductor N to the new terminal connector for the AC load (26), and then to the existing load (27) of the switched electrified point (e.g. a common bulb).

Switch (3) is bypassed with the connection of rectification circuit (e.g. a diode) (5) halfwave rectified sine period or variable half sine period. Diode (5) allows unidirectional current flow as soon as the switch is opened, that is 0<ωt<π or π<ωt<2π, depending on the direction the diode is wired to the switch (3).

It is of no significance for the implementation of the method if the rectified half period is positive (0<ωt<π) or negative (π<ωt<2π). The way the diode's anode/cathode is wired to the switch (3) is of no significance: when the cathode is connected towards the existing electrical point (4), then diode (5) allows flow during the positive half-period (0<ωt<π), while when its anode is connected towards the existing electrical point (4) then diode (5) allows flow of the negative half-period (π<ωt<2π).

Diode (5) also provides with the power required the power supply unit (6) which charges and maintains the battery (9). Diode (5) can be replaced by an electronic circuit that exhibits the same characteristic result, namely unidirectional current flow.

Power source commutator (12) switches the appliance's supply (external load 13), from power supply unit (6) during network presence, to rechargeable battery (9), during backup operation.

Furthermore, as it is shown in Drawings 1, 5, 6, 7 and 8, the microcontroller (8), includes the following program routines for implementation of the method:
8A) Start-up of the application that implements the method (Power on Reset) (8A), which performs the necessary Initialization routines of hardware and variables used in the application and the method, while in case of system failure, it can emit an optical signal by activating LED lamps (28),
8B) Auto Calibration and Diagnostics during production and continuous quality and quantitative testing during operation of the method, while in case of system failure it can emit an optical signal by activating LED lamps (28),
8C) Constant current or constant voltage Battery Charger and Battery Charge Controller, using Pulse Width Modulation method (PWM Battery Charge Control),
8D) Commutation and connection control of the DC load from the rechargeable battery or from the power supply unit (6),
8E) Voluntary or inadvertent current disruption discriminator (Switch & Power Fail Discriminator). The Microcontroller's (8) Discriminator operates in conjunction with rectification circuit (5) monitoring for existence of rectified half sine period or rectified variable half sine period.
(8Z) Existing AC load control routine, which receives a command from the Discriminator (8E) and in turn drives Relay (25) thus controlling conventional lighting.

Always in accordance with the depiction of Drawing 1, using a parallel connection cable (1) neutral conductor and cable phase conductor (2) both connect to power supply unit (6) (switch mode AC/DC supply), mentioned earlier, which is specifically designed: it includes cosine correction circuit (Cos ϕ) and generates the supply voltage required by the method's electronic circuits and external load. The power supply unit (6) is operational in a normal period (0<ωt<2π) bypassing diode (5) with switch (3) closed, as well as in a half-period (0<ωt<π) or (π<ωt<2π) of the mains electrical supply, via the rectification unit (5) with switch (3) open. Power supply unit (6) also supplies power circuit (11) battery charger, always under the control of microcontroller (8), for charging of battery (9) with constant current or constant voltage control, in accordance with the battery's technology.

Commutation Switch (7) selects the internal circuit voltage source for the operation of the Microcontroller (8), of the alternating voltage to square wave Pulse Width Modulation converter measuring circuit - PWM (10) and the battery charging circuit (11). Namely selects a) the power supply unit (6) when there is network current supply or b) the rechargeable battery (9) when there is no network current supply. Commutation switch (7) operates autonomously and by use of a transistor and two passive components, presents a very low voltage drop for better exploitation of the battery's voltage (9).

The network alternating voltage V(t) = Vpk * sine (ωt) is converted to a square wave of variable pulse width - PWM by the alternating voltage to square wave Pulse Width Modulation converter measuring circuit - PWM (10) (drawing 1 no. 10 and drawing 2) and in digital format is transmitted as time information to the microcontroller (8).

The microcontroller (8) measures the period:
If it is a full sine wave period (0<ωt<2π) then it is deduced that there is neither a general failure nor distribution board damage, but that the point is normally electrified. This measurement is owed to the fact that the rectification circuit (5) is bypassed by switch (3) being closed. The rechargeable battery does not switched into operation, but continues its charging via power supply unit (6).

If it is a half sine wave period, negative or positive, 0<ωt<π or π<ωt<2π, then it is deduced that again there is neither a general failure nor distribution board damage, but the electrification was voluntarily disrupted by the user. This measurement is owed to the fact that despite the fact that the switch is open, the rectification circuit (5) allows half-period electrical current flow (0<ωt<π or π<ωt<2π).

Thus the rechargeable battery (9) is again not switched into operation but continues its charging via power supply unit (6).

Finally, if the microcontroller (8) determines that the measured period T is equal to infinity, then it is deduced that there is a general failure (by the provider or due to distribution board damage).

In this event the rechargeable battery is switched into operation, while by default, its charging is stopped.

Simultaneously, battery charge and control circuit (8C) measures the voltage of the rechargeable battery (9) so as to determine the level of remaining charge. When the battery voltage drops below the manufacture's predefined level of minimum cutoff voltage, the circuit (8C) via commutator (12) stops the appliance's battery (9) backed up operation. The battery, however, continuous the electrical supply of commutation switch (7), microcontroller (8), alternating voltage to square wave Pulse Width Modulation converter measuring circuit - PWM (10) and battery (9) charge circuit (11), which are placed in "sleep mode" and remain in this state until network electrification is restored.

Restoration of electrification via the alternating voltage to square wave Pulse Width Modulation converter measuring circuit - PWM (10), reverts microcontroller (8) into operation ("wake-up mode") which calculates the period, and by now - since electrification has been restored- the period T is not equal to infinity. Then, via commutation switch (7) circuit switches the supply of commutation switch (7) circuit, Microcontroller (8), alternating voltage to square wave Pulse Width Modulation converter measuring circuit - PWM (10) and battery charge (11) circuits, from rechargeable battery (9) to ower supply (6) and continuous the calculation of Period T until Period T is again equal to infinity (to the next general electrical failure).

Drawing 2 depicts the arrangement of parts for the alternating voltage to square wave Pulse Width Modulation converter measuring circuit - PWM (10). As shown in drawing 2, measuring/converter unit (10) consists of: a very low operational current (185 uApk) voltage monitor integrated circuit (14), optocoupler (15), bridge rectifier (16), resistors ( 17, 18, 19, 20), Zener diode (21) and capacitor (22). Measuring unit (10) via the optocoupler circuit provides galvanically isolated width modulated pulses (PWM) according to the mathematical formula V(t) = Vpk Sin (ωt). By implementing this mathematical formula, microcontroller (8) calculates the variable T (period e.g. 20 msec for 50Hz network) and variable t (half period e.g. 10msec for 50Hz network). The calculation of magnitude for variables T and t, is imperative for the implementation of the method.

Drawings 3 and 4 depict the four different operational modes that exist at a switched electrified point when the present method is implemented, including relative waveforms based on 2 parameters: the first parameter is whether the circuit switch is open (Figures 3B & 4B) or closed (Figures 3A & 4A) and the second parameter is whether the electrification is voluntary disrupted by the user (3B) or involuntary general failure by the network provider or due to distribution board damage (4A & 4B).

Thus, drawings 3 and 4 depict the point and the corresponding waveform applicable when the method is implemented:
in the state of electricity supply present (3A),
in the state of disconnection from the supply by voluntary action, in other words by user volition, (3B),
in the state where the point is connected but there is inadvertent lack of work, not per user desire, but due to a general failure either from the provider or due to a distribution board failure (4A),
and finally in the state of the point being disconnected by the user, with a concurrent general failure by the provider, that is not at the user's wish (4B).

The waveforms of drawings 3 and 4 are presented via circuit (10) to Discriminator (8E) of Microcontroller (8).

As depicted in Drawing 1 and in Drawing 5 (flowchart) the functions executed by the Microcontroller (8) are briefly the following: Starts the application (e.g. security light) that implements the method (Power on Reset) (8A), which performs all the necessary hardware and variable Initialization routines for the application and the method.

Then follows a check for the existence, or not, of production process stored technical characteristics. This control is done by the Auto Calibration Check routine (8B). In case of a problem an optical signal is emitted by LED lamps (28).

Both of the above functions are executed only when the appliance is placed into operation for the first time, but also every time it is placed in operation after precedence of total electrical disconnection of the appliance, i.e. when the appliance had been disconnected, both, from the rechargeable battery and the electrical supply network. (Power on clear - POC).

Intentional or Inadvertent current disruption Discriminator (Switch & Power fail Discriminator) (8E), monitors for the presence of a rectified half wave sine period or variable half wave sine period. Depending on the result, Discriminator (8E) provides instructions to the Existing Load Control Routine (8Z) to energize or de-energize the Relay (25), as this will be shown detailed in designs 6 up to 8.

Following, on a command from Discriminator (8E), commutator and DC load connection controller (8D), connects supply of the external DC load (13) from the rechargeable battery (9) or the power supply unit (6) respectively.

Next, on a command from Discriminator (8E), Battery Control and Charger (8C) decides if it will continue or discontinue battery charging, as will be shown detailed in drawings 6 up to 8.

Next, a functional test of the luminary is conducted by the Auto Calibration Subroutine (8B) and finally the application which implements the program is executed (e.g. security light operation, street light lamp fail monitor, etc.).

Finally, via the Discriminator (8E) the same program flow is repeated.

In Drawing 1 and in Drawing 6 (flowchart), show in detail execution of the instructions for battery backup mode of operation in the event of total electrical network loss (T= ∞):
Discriminator (8E) (monitoring of voluntary or inadvertent AC voltage interruption) initially checks if the PWM timer for measurement of voltage (drawing 6 and drawing 8) has been started. If not, the Discriminator (8E) starts the timer. Then, Discriminator (8E) checks if the 1ms time base timer (Tick Timer) has been started. If not, the Discriminator (8E) starts the 1ms time base timer (drawing 6 and drawing 8).
Next, Discriminator (8E) monitors the condition and if the period is equal to infinity (T= ∞), then there has been a general electrical failure thus instructs existing AC Load Controller (8Z) and de-energizes Relay (25) disconnecting the AC load.

Then, instructs battery Charger and Charge Controller (8C) to interrupt battery charging (9), via charging circuit (11). With a command to Commutator and DC load connection controller (8D) switches DC Load supply, from the supply unit (6) to the rechargeable battery (9), namely starting backup operation with termination and instruction cycle repetition from point (C).

Contrary wise, if the period is not equal to infinity (T= ∞), then there has not been a general failure and the Discriminator (8E) measures the voltage V=Vpk x sine (∞t).

Drawing 1 and Drawing 7 (flowchart), depict in detail function execution, when there has not been a general failure and a 230 Vrms (vpk=230*1,414) network is present.

Discriminator (8E) checks if the voltage is less than 262 Vpk. If it is, instructs battery Charger and Charge Controller (8C) to interrupt battery (9) charging.

Next it checks if the voltage is less than 215Vpk.

If it is not, then de-energizes Relay (25) thus interrupting supply to the existing AC load (27) via the Control routine of existing AC load (8Z) and then follows an instruction repetition cycle from point (C) of drawing 6, namely the control test point of whether T= ∞.

If the voltage is less than 215 Vpk, then, via the Commutator routine and DC load connection controller (8D), sets rechargeable battery (9) into operation and switches DC load supply (13) from supply unit (6) to rechargeable battery (9), thus placing the appliance into backup operation. Next relay (25) is de-energized interrupting supply to the existing AC load (27), via the Control routine of existing AC load (8Z) and then follows an instruction repetition cycle from point (C) of drawing 6, namely the control test point of whether T= ∞.

If the voltage is not less than 262 Vpk the Discriminator (8E) checks if the voltage is more than 275 Vpk.

If the voltage is not greater than 275Vpk, then via the existing AC load (8Z) Control routine de-energizes relay (25) thus interrupting supply to the existing AC load (27), and then follows an instruction repetition cycle from point (C).

If the voltage is greater than 275Vpk, then via Commutator routine and DC load connection controller (8D), interrupts the backup operation and switches DC load (13) power supply from rechargeable battery (9) to power supply unit (6). Next a test is made if there is half period namely 0<ωt<2π or π<ω<2π. If half period exists, it is concluded that switch (3) is intentionally opened by the user, so via the existing AC load Control (8Z) Discriminator (8E) de-energizes Relay (25) and interrupts the electrification to the existing AC load, applying the user's command.

While, if there is no half period, then if there is electrification (Vt>275Vpk) it is concluded that full sine wave period 0<ωt<2π exists therefore that switch (3) is closed. Then, via the existing AC load Control (8Z) Discriminator (8E) energizes Relay (25) and electrifies the existing AC load and terminates at the Discriminator (8E)(C) and then follows an instruction repetition cycle from point (C) of drawing 6, namely the control point of whether T= ∞.

If however the voltage is not greater than 275Vpk, Discriminator (8E) via existing AC load Control (8Z) de-energizes Relay (25) and interrupts the electrification to existing AC load and executes from the beginning the instruction cycle of drawing 6 with entry at point C.

In conclusion, as depicted in the flowchart of drawings 5, 6, 7 and 8, microcontroller (8) executes a series of instructions in accordance with the programming code, with which it realizes the following functions:
a) initially calculates the instantaneous network voltage, according to the mathematical formula where V(t) = Vpk * t/T
   and then,
   either
b) if sine wave is found to exist, then electrification exists and if only half period is detected switch (3) is open while if a full period is detected switch (3) is closed, in both circumstances by user volition without occurrence of general failure, therefore user command is executed via existing AC load relay (25), while battery (9) always remains in charging mode,
   or
bb) if total lack of sine wave is detected, where T is equal to infinity, then a general failure has occurred, so operation is switched to rechargeable battery (9) operation and via the power circuit (12) connects the external load (13) which may be a light bulb, a GSM/GPRS/GPS modem for transmission of information via the serial channel, of the fault's geographical coordinates, etc.

In reference to the appliance that implements the method (drawings 9 up to 12):
Drawings 9, 10, 11 and 12 depict forms of the appliance which implements the present method when there is a general failure, caused by the provider, or due to distribution board failure.

Drawings 9 and 10 depict the electrical layout of the appliance when it incorporates its own rechargeable battery, thus constituting a new autonomous appliance, that can be used e.g. (in drawing 9) for installation in urban lighting poles whereby using, telematic methods, to inform the control center about the existence of a problem (block of street lights out of service, interruption etc.), while by GPS technology (Global Positioning System), be able to notify geographical coordinates of the damage, or where (in drawing 10) be able to be used as an autonomous safety luminary with LED lamps.

Drawing 11 and 12 depicts the electrical layout of the appliance when it does not incorporate its own rechargeable battery and is connected between the switched electrified point and the circuit of a safety luminary of the current state of art (drawing 11), using a serial channel, e.g. I2C, SPI, UART, as well as the connection method (drawing 12).

Drawings 9, 10 and 11 have, in majority, a common electrical layout and differ in the segment of their specific implementation, namely:
As shown in designs 9, 10 and 11 the neutral conductor cable (1) ("N"), is distributed to all electrical points switched or not, such as switches, plugs incorporating switches, etc., and leads to the electrical point of connection (terminal connector) (4). Also, phase conductor (2) ("L"), via switch (3) is also routed to electrical point connection (terminal connector) (4).

Then, the two wires connect to power unit (6) and to alternating voltage converter to Pulse Width Modulation measuring circuit - PWM (10). Phase conductor L connects to existing AC load relay control unit (25) and terminates with the neutral conductor N to the new AC load terminal connector (26), and then to switched point's existing load (27).

Switch (3) is bypassed with half wave or variable half wave rectifier diode (5).

Diode (5) supplies required power to power supply unit (6) which charges and maintains battery (9), whether this battery belongs to the appliance (drawings 9 and 10) or this battery belongs to the emergency luminary in which the appliance is embedded (designs 11 and 12). Power supply unit (6) also supplies battery charging power circuit (11), always under the control of the microcontroller (8) for charging of battery (9).

Power supply unit (6) has cosine (Cos ϕ) correction circuit and generates the supply voltage required by the electronic circuits of the appliance. Power supply unit (6) is operable insomuch a normal period (0<ω<2π) with switch (3) bypassing diode (5), as in half period (0<ω<π) or (π<ω<2π) of the electrical sine wave supply, via rectifier diode (5) with switch (3) open.

Microcontroller (8) of the appliance includes program routines that were mentioned above during the Description of the method, namely
Application Start (Monitor) (8A),
Auto Calibration - Diagnostics (8B),
Battery charging control (8C),
Rechargeable battery to load connection controller (8D)
Discriminator of voluntary or inadvertent current interruption (8E) κατ
Existing load control (8Z).

In case of system fault, Application (8A) and Diagnostics routine (8B) can activate led lamps (28) to emit an optical signal.

The microcontroller (8) calculates the period.

If the period is 0<ωt<2π, the user's command is executed, namely the existing AC load is electrified via relay (25). The rechargeable battery does not enter in operation but continues its charging via the supply unit (6). Simultaneously the commutation switch (7) selects power supply unit (6) as the internal voltage source for the operation circuits.

If the period is 0<ωt<π or π<ωt<2π, again the user's command is executed, namely supply of the existing AC load is discontinued. The rechargeable battery once again does not go into operation but continues charging via the power supply unit (6). Simultaneously the commutation switch (7) selects power supply unit (6) as the internal voltage source for the operation of circuits.

Finally, if the microcontroller (8) determines that the period measured is equal to infinity, then a general failure by the provider or due to distribution board failure has occurred, in which case rechargeable battery enters operation and its charging is discontinued. Simultaneously, commutation switch (7) selects as the internal voltage source for the operation of circuits, rechargeable battery (9).

As depicted in drawing 9, as soon as electrification is interrupted, rechargeable battery (9) supplies GSM/GPRS Modem device and GPS system (32) in order to convey to the relevant control center of urban or national road lighting installation or of factories or of offices, the information that a section (block) of street lighting bulbs has been put out of service due to electrification interruption or "burned out" fuse, or that a specific light bulb is malfunctioning/burned out and sent the exact geographical coordinates of the point of failure. Current sensor (33) is used for the detection. Rechargeable battery operation continues until the battery's voltage drops below the manufacture's predefined minimum cut out voltage level, in which case commutator (12) interrupts backup battery (9) connection to the GSM/GPRS Modem devices and GPS system. However, battery (9) continues to supply the appliance's circuits, which are placed in "sleep mode" and remain in this mode until the network supply is restored.

Drawing 10 depicts the appliance as backup light (safety luminary). Specifically, when the network voltage is 185 Vrms charging of the battery is interrupted. When the network voltage drops below 150 Vrms, via battery rechargeable battery (9), switch mode constant current, voltage stepup converter (23) is put into operation which in turn drives array of led lamps (24) and simultaneously Relay (25) is de-energized. When the voltage rises over 165Vrms, then operation of switch mode stepup converter (23) is interrupted resulting in led lamps (24) being turned off and when the voltage rises over 190Vrms then charging of rechargeable battery (9) is reinstated and relay (25) is enabled which respectively supplies existing AC load (27), in accordance with switch (3) command.

In drawings 11 and 12 the appliance is depicted as an autonomous appliance subsystem (module) which is embedded in an appliance of uninterruptible or emergency operation, namely an external host appliance which uses its own rechargeable battery (design 11), as well as the electrical layout (design 12). In this case, the appliance is inserted between the switched electrified point and the safety luminary (Host) circuitry.

The battery charging power circuit (11) is connected to the rechargeable battery of the host appliance with intervention of dual terminal connectors (30 & 31). The two terminal connectors will be inserted between the rechargeable battery, already provided by the host luminary, and the point where the battery was previously connected to the safety luminary (Host).

With this connection, power commutator circuit (12) supplies the host appliance. Communication of Microcontroller (8) with the Microcontroller of the host appliance is done via serial channel (29) which is adapted to the requirements of the host appliance, such as I2C, SPI, UART.

Also, with this connection, a safety luminary of the current state of the art, can now be installed at a point of switched electrification.

The present method and the appliance implementing it, can certainly be installed and be operational at a non switched but continuously electrified point, without use of rectifying circuit (5).

## Claims

1. Method for the detection of current interruption which is **characterized in that** it
a) can be applied to a switched electrified point that is supplied by a phase conductor (L; 2) and a neutral conductor (N; 1), without a third conductor of permanent current supply,
b) creates a new switched connection point controlled by a relay (25), which leads to an AC load connection and
c) charges a rechargeable battery (9) using a rectifying circuit (5) that bypasses switch (3), and which discerns whether:
- a general electrification interruption occurred, in particular caused by the provider or due to a distribution board failure, or
- an electrification interruption occurred intentionally by the user via the switch (3), or
- an electrification interruption has not occurred,
and executes, with the help of a Microcontroller (8), the following steps:
1) a PWM converter (10), i.e. pulse width modulation converter, converts the AC voltage to digital time information in accordance with the network alternating voltage waveform V(t)=Vpk*sin(ωt),
2) the microcontroller (8) measures the time of a half period (t) and a period (T), calculates their ratio t/T and concludes:
3) if a total lack of the sine wave is detected, then there is a general current failure, in which case charging of the rechargeable battery (9) and supply to the AC load (27) is discontinued, while external loads (13) are supplied by the rechargeable battery (9),
4) if a positive, 0 < ωt < π, or negative, π < ωt < 2π, half sine period is detected, then there is no general failure, but switch (3) has been intentionally opened by the user and the half sine period current flow is due to a rectification circuit (5) which bypasses switch (3), in which case electrification to the AC load is interrupted in accordance to the user's command, and the rechargeable battery continues its charging via power supply unit (6),
5) whereas if no half sine period is detected while electrification exists, then a whole sine period exists 0< ωt <2π and the switch (3) has been intentionally closed by the user, so that the current flow during the whole sine wave period is due to the closed switch (3), which bypasses the rectification circuit (5), and electrification of AC load (27) continues in accordance with the user's command, and charging of rechargeable battery continues via power supply unit (6).

2. Method for the detection of current interruption in accordance with claim 1, which is **characterised by** that:
Alternating voltage to Pulse Width Modulation converter measuring circuit - PWM (10) converts alternating network voltage to square wave Pulse Width Modulation - PWM and transfers this as time to Microcontroller (8), which measures the period (T) and
if it finds that the measured period is T = infinity, then is deduced that there is general current failure, in which case the following steps are executed:
1. AC load is disconnected via Relay (25),
2. charging of the rechargeable battery (9) is discontinued
3. supply of DC load is switched from power supply unit (6) to rechargeable battery (9),
4. voltage measurement of rechargeable battery (9) continues,
5. when the battery voltage reaches the low voltage cutout limit as dictated by its manufacturer, via commutator (12) its use is restricted to the electrification of the circuits of commutator switch (7) Microcontroller (8), PWM (10) circuit, and charging circuit (11), in "sleep mode" state,
6. at restoration of electrification, microcontroller (8) operation is reinstated "wakeup mode" via PWM (10) circuit, and once again starts period measurement,
7. power supply of commutator switch circuit (7), microcontroller (8), PWM (10) circuit and battery charging (11), is switched from rechargeable battery (9) to power supply unit (6) via commutator switch circuit (7),
8. until period T becomes once again equal to infinity (at the next general interruption of electrification) where the above steps are again repeated.

3. Method for detection of current interruption in accordance with claims 1 and 2, which is **characterized by** that it is implemented in the same manner using instead of rechargeable batteries, capacitors or super capacitors.

4. Method for detection of current interruption in accordance with claims 1 to 3 which is **characterized by** that the diode (5) can be replaced by an electronic circuit which leads to the same technical result, that is unidirectional current flow.

5. Method for detection of current interruption in accordance with claims 1 to 4 which is **characterized by** that it is implemented in the same manner when there is no general failure but a drop in voltage, as the meaning is defined by international organizations pertaining to safety systems.

6. Method for detection of current interruption in accordance with claims 1 to 3 which is **characterized by** that if use of diode 5 is abolished, the implementation of the method is restricted to continuously electrified point.

7. Device for the detection of a current interruption, **characterized by** that it consists of:
- a microcontroller (8),
- a power supply unit (6), in particular a switched mode AC/DC converter, which includes a power factor correction circuit,
- an alternating voltage to square wave Pulse Width Modulation converter measuring circuit, i.e. PWM converter (10),
- a battery charging power circuit (11),
- a commutator switch (7), which selects the internal voltage source for the operation of circuits of the Microcontroller (8), the PWM Converter (10), and the battery charging circuit (11),
- a power source commutator (12) which switches the supply source for the device from the power supply unit (6) to the rechargeable battery (9) during back up operation,
- a control relay (25) for an existing AC load (27)
- a new terminal block AC load (26) connection,
the device being connected to the phase (L; 2) and neutral (N; 1) conductor terminals, via switched electrified point (3), inserted between an existing electrical point (4) and a new connection point (26), and operates in combination with a rectifying circuit (5) which is placed across switch (3), bypassing it when it is open,
and also being connected, via a serial channel (29), to a host device of uninterruptible or emergency operation incorporating its own rechargeable battery, the battery charging power circuit (11) being connected to the rechargeable battery of the host appliance with intervention of dual terminal connectors (30, 31),
the PWM converter (10) converting the AC voltage to digital time information in accordance with the network alternating voltage waveform V(t)=Vpk·sin(ωt),
the microcontroller (8) measuring the time of a half period (t) and a period (T), calculating their ratio t/T and concluding:
1) if a total lack of the sine wave is detected, then there is a general current failure, in which case charging of the rechargeable battery (9) and supply to the AC load (27) is discontinued, while external loads (13) are supplied by the rechargeable battery (9),
2) if a positive, 0 < ωt < π, or negative, π < ωt < 2π, half sine period is detected, then there is no general failure but switch (3) has been intentionally opened by the user and the half sine period current flow is due to a rectification circuit (5) which bypasses switch (3), in which case electrification to the AC load is interrupted in accordance to the user's command, and the rechargeable battery continues its charging via power supply unit (6),
3) whereas if no half sine period is detected while electrification exists, then a whole sine period exists 0< ωt <2π and the switch (3) has been intentionally closed by the user, so that the current flow during the whole sine wave period is due to the closed switch (3), which bypasses the rectification circuit (5), and electrification of AC load (27) continues in accordance with the user's command, and charging of rechargeable battery continues via power supply unit (6).

8. Device for the detection of current interruption in accordance with claim 7, which is **characterized by** that it may additionally have its own rechargeable battery (9), current sensor (33) to diagnose light bulb failure, and external wireless information transmission devices (32), in which case via power circuit (12) and via serial channel (29), transmits information resulting from the implementation of the method, not only for general mains failure, but also for light bulb damage, as well as problem specific geographical coordinates.

9. Device for detection of current interruption in accordance with claims 7 to 8, which is **characterized by** that it may have its own rechargeable battery (9), switch mode constant current voltage stepup converter (23) which in turn drives array of led lamps (24), thus constituting an autonomous safety luminary.

10. Device for detection of current interruption in accordance with claims 7 to 9, which is **characterized by** that it is placed between switched electrified point via terminal connector (4), and electrified load (27), which henceforth is connected to the new connection point, terminal connector (26) via relay (25).

11. Device for the detection of current interruption in accordance with claims 7 to 10, which is **characterized by** that it has led lamps (28), with which the microcontroller (8) emits an optical signal in case of system failure.

12. Device for the detection of current interruption in accordance with claims 7 to 11, which is **characterized by** that it provides galvanic isolation from the network of all electronic circuits and batteries.

13. Device for the detection of current interruption in accordance with claims 7 to 12, which is **characterized by** that the rechargeable battery (9) can be replaced by capacitors or super-capacitors.

## Patentansprüche

1. Verfahren zur Feststellung der Stromunterbrechung, das **dadurch gekennzeichnet ist, dass** es
a) an einem elektrischen Schaltpunkt angewandt werden kann, der von einem Phasenleiter (L; 1) und einem Nullleiter (N; 1), ohne einen dritten Leiter, mit Dauerstrom gespeist wird,
b) eine neu geschaltete Anschlussstelle setzt, die durch ein Relais (25) gesteuert wird, und die zu einer Wechselstrom-Lastzuschaltung führt, und
c) einen Akku (9) auflädt, wobei es eine Gleichrichterschaltung (5) benutzt, die den Schalter (3) überbrückt und erkennt, ob:
- ein insbesondere durch den Stromversorger oder das Versagen des Sicherungskastens verursachter allgemeiner Stromausfall vorliegt, oder ob
- ein vom Benutzer über den Schalter (3) absichtlich herbeigeführter Stromausfall vorliegt, oder ob
- kein Stromausfall vorliegt,
und mit Hilfe des Mikrokontrollers (8) folgende Schritte durchführt:
1) ein PWM-Konverter (10), d.h. ein Pulsweitenmodulationswandler, konvertiert die Wechselstromspannung in digitale Zeitinformation gemäß der Wellenform der Netzwerkwechselstromspannung V(t)=Vpk*in(ωt),
2) der Mikrokontroller (8) misst die Zeit einer halben Periode (t) und einer ganzen Periode (T), errechnet deren Verhältnis t/T, und kommt zu folgenden Schlüssen:
3) wenn ein totaler Ausfall der Sinusschwingung festgestellt wird, dann besteht ein allgemeiner Stromausfall, in welchem Fall das Aufladen des Akku (9) und die Speisung der Wechselstrombelastung (27) unterbrochen wird, während externe Belastungen (13) vom Akku (9) gespeist werden,
4) wenn eine positive - 0 < ωt < π - oder eine negative - π <ωt <2π - halbe Periode der Sinusschwingung festgestellt wird, dann besteht kein allgemeiner Stromausfall, sondern der Schalter (3) wurde vom Benutzer absichtlich eingeschaltet und der Stromfluss von einer halben Periode der Sinusschwingung wird durch die Gleichrichterschaltung (5) verursacht, die den Schalter (3) überbrückt, in welchem Fall die Speisung der Wechselstrombelastung auf Befehl des Benutzers unterbrochen wird und der Akku sich über das Netzanschlussgerät (6) weiter auflädt,
5) wohingegen dann, wenn keine halbe Periode der Sinusschwingung festgestellt wird, obwohl Strom fließt, dann eine ganze Periode der Sinusschwingung 0 < ωt < 2π vorliegt und der Schalter (3) vom Benutzer absichtlich geschlossen worden ist, so dass der Stromfluss für eine ganze Periode der Sinusschwingung dank des geschlossenen Schalters (3) besteht, der die Gleichrichterschaltung (5) überbrückt, und die Speisung der Wechselstrombelastung (27) erfolgt gemäß der Anweisung des Benutzers und das Aufladen des Akku durch das Netzanschlussgerät (6) wird fortgesetzt.

2. Verfahren zur Feststellung der Stromunterbrechung in Übereinstimmung mit Anspruch 1, das wie folgt gekennzeichnet ist:
Die Wechselspannung zum Pulsweitenmodulationswandler-Messkreis - PWM (10) konvertiert die Wechselspannung des Netzes zum Quadrat der Pulsweitenmodulation - PWM (10) und überträgt diese diesmal zum Mikrokontroller (8), der die Periode (T) misst, und,
wenn er feststellt, dass die gemessene Periode T = unendlich ist, schließt er daraus, dass ein allgemeiner Stromausfall vorliegt, in welchem Fall er folgende Schritte vornimmt:
1. Die Wechselstrombelastung wird über das Relais (25) abgeschaltet,
2. die Ladung des Akku (9) wird unterbrochen,
3. die Speisung mit Gleichstrombelastung wird vom Netzanschlussgerät (6) auf den Akku (9) umgeschaltet,
4. die Spannungsmessung des Akku (9) wird fortgesetzt,
5. wenn die Batteriespannung die vom Hersteller vorgesehene Ausschaltgrenze für Niedrigspannung erreicht, wird über einen Umschalter (12) ihr Gebrauch auf die Speisung der Schaltungen des Umschalter-Schalters (7), des Mikrokontrollers (8), des PWM-Schaltkreises (10) und der Akkuladeschaltung (11) in den Ruhezustand ("Sleep-Modus") beschränkt,
6. bei Wiederaufnahme der Stromzuführung wird der Betrieb des Mikrokontrollers (8) über den PWM-Schaltkreis (10) wieder in den "Aufweckmodus" gesetzt und die Periodenmessung beginnt von neuem,
7. die Stromversorgung für den Umwandlerschaltkreis (7), den Mikrokontroller (8), den PWM - Schaltkreis (10) und die Ladung der Batterie (11) wird vom Akku (9) auf das Netzanschlussgerät (6) mittels des Umwandlerschaltkreises (7) umgeschaltet,
8. bis die Periode T wieder gleich unendlich wird (bei der nächsten allgemeinen Stromunterbrechung), wonach obige Schritte wiederholt werden.

3. Verfahren zur Feststellung der Stromunterbrechung gemäß der Ansprüche 1 und 2, das **dadurch gekennzeichnet ist, dass** es auf die gleiche Weise durchgeführt wird, wobei anstatt Akkus Kondensatoren oder Superkondensatoren benutzt werden.

4. Verfahren zur Feststellung der Stromunterbrechung gemäß der Ansprüche 1 bis 3, das **dadurch gekennzeichnet ist, dass** die Diode (5) durch einen elektronischen Schaltkreis ersetzt werden kann, was zum gleichen technischen Ergebnis führt, d.h. zu einem unidirektionalem Stromfluss.

5. Verfahren zur Feststellung der Stromunterbrechung gemäß der Ansprüche 1 bis 4, das **dadurch gekennzeichnet ist, dass** es auf die gleiche Weise durchgeführt wird, wenn kein allgemeiner Stromausfall sondern ein Spannungsabfall im Sinne der die Sicherheitssysteme betreffenden Definition seitens internationaler Organisationen vorliegt.

6. Verfahren zur Feststellung der Stromunterbrechung gemäß der Ansprüche 1 bis 3, das **dadurch gekennzeichnet ist, dass** dann, wenn die Benutzung der Diode (5) entfällt, die Durchführung des Verfahrens auf eine ständig mit Strom versorgte Anschlussstelle (Steckdose) eingeschränkt ist.

7. Apparat zur Feststellung der Stromunterbrechung, der **dadurch gekennzeichnet ist, dass** er besteht aus:
- einem Mikrokontroller (8),
- einem Netzanschlussgerät (6), insbesondere ein modulares AC/DC-Wandler-Netzteil, das eine Leistungsfaktor-Korrekturschaltung enthält,
- einem wechselnde Spannungen in Rechteckimpulse modulierenden Pulsweitenmodulationswandler-Strom-Messkreis, d.h. PWM-Wandler (10),
- einem Batterielade-Netzgerät (11),
- einem Umschalter (7), der die interne Spannungswelle für den Betrieb der Mikrokontroller-Schaltung (8), den PWM-Wandler (10) und die Batterie-Ladeschaitung (11) selektiert,
- ein Stromquellenwandler (12), der während des Backup-Betriebs die Versorgungsquelle für das Gerät von dem Netzgerät (6) zum Akku (9) umschaltet,
- einem Steuer-Relais (25) für die bestehende Wechselströmbelastung (27),
- einem neuen Netzanschluss-Klemmenblock (26) für die Wechselstrombelastung,
wobei der Apparat an Phasenleiter (L; 2) - und neutrale Leiter (N; 1) - Terminals über eine bestehende, eingeschaltete Anschlußstelle (3) angeschlossen ist, die zwischen einer bestehenden Anschlussstelle (4) und einer neuen Anschlussstelle (26) eingefügt ist, und in Verbindung mit einer Gleichrichterschaltung (5) arbeitet, die über dem Schalter (3) angeordnet ist und diesen überbrückt, wenn er eingeschaltet wird,
und ebenso über einen seriellen Kanal (29) an ein Host-Gerät angeschlossen ist, das unterbrechungsfrei bzw. im Notbetrieb mit einem eigenen eingebauten Akku arbeitet, wobei der Akku-Ladestromkreis (11) an den Akku des Host-Geräts unter Einschaltung dualer Anschlussklemmen (30, 31) angeschlossen ist,
wobei der PWM-Konverter (10) die Wechselstromspannung in digitale Zeitinformation gemäß der Wellenform der NetzwerkWechselstromspannung V(t)=Vpk*sin(ωt) umwandelt,
der Mikrokontroller (8) die Zeit einer halben Periode (t) und einer ganzen Periode (T) misst, deren Verhältnis t/T errechnet und zu folgenden Schlüssen kommt:
1) wenn ein totaler Ausfall der Sinusschwingung festgestellt wird, dann besteht ein allgemeiner Stromausfall, in welchem Fall das Aufladen des Akku (9) und die Speisung der Wechselstrombelastung (27) unterbrochen wird, während externe Belastungen (13) vom Akku (9) gespeist werden,
2) wenn eine positive - 0 < ωt < π - oder negative - π <ωt <2π - halbe Periode der Sinusschwingung festgestellt wird, dann besteht kein allgemeiner Stromausfall, sondern der Schalter (3) wurde vom Benutzer absichtlich eingeschaltet, und der Stromfluss von einer halben Periode der Sinusschwingung wird durch die Gleichrichterschaltung (5) verursacht, die den Schalter (3) überbrückt, in welchem Fall die Speisung der Wechselstrombelastung auf Befehl des Benutzers unterbrochen wird und der Akku sich über das Netzanschlussgerät (6) weiter auflädt,
3) wohingegen dann, wenn keine halbe Periode der Sinusschwingung festgestellt wird, obwohl Strom fließt, dann eine ganze Periode der Sinusschwingung 0 < ωt< 2π vorliegt und der Schalter (3) vom Benutzer absichtlich geschlossen wurde, so dass der Stromfluss für eine ganze Periode der Sinusschwingung dank des geschlossenen Schalters (3) besteht, der die Gleichrichterschaltung (5) überbrückt, und die Speisung der Wechselstrombelastung (27) gemäß der Anweisung des Benutzers erfolgt, und das Aufladen des Akku durch das Netzanschlussgerät (6) fortgesetzt wird.

8. Apparat zur Feststellung der Stromunterbrechung in Übereinstimmung mit Anspruch 7, der **dadurch gekennzeichnet ist, dass** er zusätzlich seinen eigenen Akku (9), einen Stromsensor (33) zur Feststellung eines Lampenausfalls und externe, drahtlose Informationsübermittlungsgeräte (32) besitzt, in welchem Fall über den Stromkreis (12) und über den seriellen Kanal (29) Informationen übermittelt werden, die aus der Durchführung des Verfahrens resultieren, nicht nur über den allgemeinen Stromausfall, sondern auch über den Lampenausfall sowie problemspezifische geographische Koordinaten.

9. Apparat zur Feststellung der Stromunterbrechung in Übereinstimmung mit den Ansprüchen 7 und 8, der **dadurch gekennzeichnet ist, dass** er seinen eigenen Akku (9) besitzen kann, einen Switch-mode-Konstantstrom-step-up-Spannungswandler (23), welcher wiederum eine Anordnung roter Leuchtdioden LED (24) betreibt, und dadurch eine autonome Sicherheitsbeleuchtung bildet.

10. Apparat zur Feststellung der Stromunterbrechung in Übereinstimmung mit den Ansprüchen 7 bis 9, der **dadurch gekennzeichnet** ist, das er über eine Anschlussklemme (4)verfügt, die zwischen einem geschalteten Stromanschluss und einer elektrischen Ladung (27) platziert ist, welche fernerh-in mit einer neuen Anschlussstelle, der Anschlussklemme (26), über ein Relais (25) verbunden ist.

11. Apparat zur Feststellung der Stromunterbrechung in Übereinstimmung mit den Ansprüchen 7 bis 10, der **dadurch gekennzeichnet ist, dass** er über rote Leuchten (28) verfügt, durch die der Mikrokontroller (8) bei Stromausfall ein optisches Signal sendet.

12. Apparat zur Feststellung der Stromunterbrechung in Übereinstimmung mit den Ansprüchen 7 bis 11, der **dadurch gekennzeichnet ist, dass** er die galvanische Trennung aller elektronischen Schaltungen und Batterien vom Netz ermöglicht.

13. Apparat zur Feststellung der Stromunterbrechung in Übereinstimmung mit den Ansprüchen 7 bis 12, der **dadurch gekennzeichnet ist, dass** der Akku (9) durch Kondensatoren oder Superkondensatoren ersetzt werden kann.

## Revendications

1. Méthode pour la détection d'interruption de courant qui est **caractérisée en ce qu'**elle
a) peut être appliquée à un point commuté électrifié qui est fourni par un conducteur de phase (L; 2) et un conducteur neutre (N; 1), sans un troisième conducteur d'alimentation en courant permanente,
b) crée un nouveau point commuté de connexion contrôlé par un relais (25) qui conduit à une connexion de charge CA et
c) charge une batterie rechargeable (9) à l'aide d'un circuit redresseur (5) qui contourne l'interrupteur (3), et discerne si:
- une interruption générale d'électrification a eu lieu, provoquée notamment par le fournisseur ou à cause d'une défaillance du tableau de distribution, ou
- une interruption d'électrification a eu lieu intentionnellement par l'utilisateur au moyen de l'interrupteur (3), ou
- une interruption d'électrification n'a pas eu lieu,
et exécute, avec l'aide d'un microcontrôleur (8), les étapes suivantes:
1) un convertisseur MIL (10), c'est-à-dire un convertisseur de modulation d'impulsions en largeur, convertit la tension alternée en information numérique de temps conformément à la forme d'onde de tension alternative du réseau V(t)=Vpk*sin(ωt),
2) le microcontrôleur (8) mesure le temps d'une demi-période (t) et d'une période (T), calcule leur rapport t/T et conclut:
3) si un manque total de l'onde sinusoïdale est détecté, alors il y a une absence de courant générale, et dans ce cas, le chargement de la batterie rechargeable (9) et l'alimentation à la charge CA (27) est interrompue, tandis que les charges extérieures (13) sont alimentées par la batterie rechargeable (9),
4) si une demi-période sinusoïdale positive, 0 <ωt <π, ou négative, π <ωt <2π, est détectée, alors il n'y a pas de défaillance générale, mais l'interrupteur (3) a été intentionnellement ouvert par l'utilisateur et le débit de courant de la demi-période sinusoïdale est dû à un circuit redresseur (5) qui contourne l'interrupteur (3), et en ce cas, l'électrification à la charge CA est interrompue conformément à l'ordre de l'utilisateur et la batterie rechargeable continue son chargement par le bloc d'alimentation (6),
5) tandis que si aucune demi-période sinusoïdale est détectée pendant que l'électrification existe, alors une période sinusoïdale entière existe 0 <ωt <2π et l'interrupteur (3) a été intentionnellement fermé par l'utilisateur, pour que le débit de courant durant toute la période de l'onde sinusoïdale soit dû à l'interrupteur fermé (3), qui contourne le circuit redresseur (5) et l'électrification de la charge CA (27) continue conformément à l'ordre de l'utilisateur et le chargement de la batterie rechargeable continue par le bloc d'alimentation (6).

2. Méthode pour la détection d'interruption de courant conformément à la revendication 1, qui est **caractérisée en ce que**:
La tension alternative au circuit de mesure du convertisseur de modulation d'impulsions en largeur - MIL (10) convertit la tension alternative du réseau en une modulation d'impulsions en largeur d'onde carrée - MIL et la transfère comme du temps sur le microcontrôleur (8), qui mesure la période (T) et
si cela constate que la période mesurée est T = infini, alors on en déduit qu'il y a un manque de courant general, et dans ce cas, les étapes suivantes sont exécutées:
1. la charge CA est débranchée par le relais (25),
2. le chargement de la batterie rechargeable (9) est interrompu,
3. l'alimentation de la charge DC passe du bloc d'alimentation (6) à la batterie rechargeable (9),
4. la mesure de tension de la batterie rechargeable (9) continue,
5. lorsque la tension de la batterie atteint la limite d'interruption à basse tension selon l'ordre de son fabricant, par un collecteur (12), son utilisation est limitée à l'électrification des circuits de l'interrupteur à collecteur (7), du microcontrôleur (8), du circuit MIL (10) et du circuit de charge (11), en mode "veille",
6. lors du rétablissement de l'électrification, l'opération du microcontrôleur (8) est rétablie en "réveil" par le circuit MIL (10) et commence une fois de plus la mesure de la période,
7. l'alimentation du circuit de l'interrupteur à collecteur (7), du microcontrôleur (8), du circuit MIL (10) et du chargement de la batterie (11) passe de la batterie rechargeable (9) au bloc d'alimentation (6) par le circuit de l'interrupteur à collecteur (7),
8. jusqu'à ce que la période T redevienne égale à l'infini (à la prochaine interruption générale de l'électrification) où les étapes ci-dessus sont à nouveau répétées.

3. Méthode pour la détection d'interruption de courant conformément aux revendications 1 et 2, qui est **caractérisée en ce qu'**elle est mise en oeuvre de la même manière en utilisant des condensateurs ou des supercondensateurs à la place des batteries rechargeables.

4. Méthode pour la détection d'interruption de courant conformément aux revendications 1 à 3, qui est **caractérisée en ce que** la diode (5) peut être remplacée par un circuit électronique qui conduit au même résultat technique, c'est-à-dire un débit de courant unidirectionnel.

5. Méthode pour la détection d'interruption de courant conformément aux revendications 1 à 4, qui est **caractérisée en ce qu'**elle est mise en oeuvre de la même manière quand il n'y a pas de défaillance générale, mais une chute de tension, comme le sens est défini par des organisations internationales se rapportant aux systèmes de sécurité.

6. Méthode pour la détection d'interruption de courant conformément aux revendications 1 à 3, qui est **caractérisée en ce que** si l'utilisation de la diode (5) est abolie, la mise en oeuvre de la méthode est limitée à un point électrifié en continu.

7. Dispositif pour la détection d'interruption de courant, **caractérisé en ce qu'**il consiste en:
- un microcontrôleur (8),
- un bloc d'alimentation (6), en particulier un convertisseur à découpage CA/DC, qui comprend un circuit compensé,
- une tension alternative au circuit de mesure du convertisseur d'une modulation d'impulsions en largeur d'onde carrée, c'est-à-dire un convertisseur MIL (10),
- un circuit de puissance de chargement de batterie (11),
- un interrupteur à collecteur (7), qui sélectionne la source de tension interne pour le fonctionnement des circuits du microcontrôleur (8), du convertisseur MIL (10) et du circuit de chargement de batterie (11),
- un collecteur à tension d'alimentation (12) qui fait passer la source d'alimentation pour le dispositif du bloc d'alimentation (6) à la batterie rechargeable (9), pendant l'opération de sauvegarde,
- un relais de commande (25) pour une charge CA actuelle (27)
- une nouvelle connexion de bloc de jonction de charge CA (26),
le dispositif étant connecté aux bornes du conducteur de phase (L; 2) et du conducteur neutre (N; 1), par un point commuté électrifié (3), inséré entre un point électrique actuel (4) et un nouveau point de connexion (26) et il fonctionne en combinaison avec un circuit redresseur (5) qui est placé à travers de l'interrupteur (3), en le contournant quand il est ouvert,
et étant également connecté, par une voie en série (29), à un dispositif hôte d'opération sans interruption ou de secours incorporant sa propre batterie rechargeable, tandis que le circuit de chargement de batterie (11) est connecté à la batterie rechargeable de l'appareil hôte avec l'intervention des connecteurs de doubles bornes (30, 31),
un convertisseur MIL (10), convertissant la tension alternée en information numérique de temps conformément à la forme d'onde de tension alternative du réseau V(t)-Vpk*sin(ωt),
le microcontrôleur (8) mesurant le temps d'une demi-période (t) et d'une période (T), calculant leur rapport t/T et concluant:
1) si un manque total de l'onde sinusoïdale est détecté, alors il y a une absence de courant générale, et dans ce cas, le chargement de la batterie rechargeable (9) et l'alimentation à la charge CA (27) est interrompue, tandis que les charges extérieures (13) sont alimentées par la batterie rechargeable (9),
2) si une demi-période sinusoïdale positive, 0 <ωt <π, ou négative, π <ωt <2π, est détectée, alors il n'y a pas de défaillance générale, mais l'interrupteur (3) a été intentionnellement ouvert par l'utilisateur et le débit de courant de la demi-période sinusoïdale est dû à un circuit redresseur (5) qui contourne l'interrupteur (3) et en ce cas, l'électrification à la charge CA est interrompue conformément à l'ordre de l'utilisateur et la batterie rechargeable continue son chargement par le bloc d'alimentation (6),
3) tandis que si aucune demi-période sinusoïdale est détectée pendant que l'électrification existe, alors une période sinusoïdale entière existe 0 <ωt <2π et l'interrupteur (3) a été intentionnellement fermé par l'utilisateur, pour que le débit de courant durant toute la période de l'onde sinusoïdale soit dû à l'interrupteur fermé (3), qui contourne le circuit redresseur (5) et l'électrification de la charge CA (27) continue conformément à l'ordre de l'utilisateur et le chargement de la batterie rechargeable continue par le bloc d'alimentation (6).

8. Dispositif pour la détection d'interruption de courant conformément à la revendication 1, qui est **caractérisé en ce qu'**il peut avoir en outre sa propre batterie rechargeable (9), son capteur à courant (33) pour identifier la panne de l'ampoule et ses dispositifs externes de transmission d'informations sans fil (32), et dans ce cas, il transmet les informations résultant de la mise en oeuvre de la méthode, par le circuit de puissance (12) et la voie en série (29), non seulement pour une panne du secteur générale, mais aussi pour un défaut de l'ampoule, ainsi que des coordonnées géographiques spécifiques au problème.

9. Dispositif pour la détection d'interruption de courant conformément aux revendications 7 à 8, qui est **caractérisé en ce qu'**il peut avoir sa propre batterie rechargeable (9), son convertisseur multiplicateur de tension à courant constant de mode d'un interrupteur (23) qui entraîne un ensemble de lampes à DEL (24) une par une, en constituant un luminaire de sécurité autonome.

10. Dispositif pour la détection d'interruption de courant conformément aux revendications 7 à 9, qui est **caractérisé en ce qu'**il est placé entre le point commuté électrifié par le connecteur de borne (4) et la charge électrifiée (27), qui est désormais connectée au nouveau point de connexion, au connecteur de borne (26) par un relais.

11. Dispositif pour la détection d'interruption de courant conformément aux revendications 7 à 10, qui est **caractérisé en ce qu'**il a des lampes à DEL (28) avec lesquelles le microcontrôleur (8) émet un signal visible en cas de défaillance du système.

12. Dispositif pour la détection d'interruption de courant conformément aux revendication 7 à 11, qui est **caractérisé en ce qu'**il fournit une isolation galvanique du réseau de tous les circuits électroniques et les batteries.

13. Dispositif pour la détection d'interruption de courant conformément aux revendications 7 à 12, qui est **caractérisé en ce que** la batterie rechargeable (9) peut être remplacée par des condensateurs ou des supercondensateurs.
